# EUROPEAN PATENT SPECIFICATION

(11) **EP 0 204 336 B1**
(45) Date of publication and mention of the grant of the patent: **04.08.1993**
(21) Application number: 86107628.9
(22) Date of filing: 05.06.1986
(51) Int. Cl.: H01L 29/60, H01L 29/06, H01L 29/78, H01L 27/08

(54) **MIS FET Semiconductor device with reduced leakage current**
MISFET-Halbleiteranordnung mit verminderten Leckstrom
Dispositif semi-conducteur MISFET à courant de fuite réduit

(30) Priority: 07.06.1985 JP 123646/85
(43) Date of publication of application: 10.12.1986
(73) Proprietor: FUJITSU LIMITED, Kawasaki-shi, Kanagawa 211 (JP)
(72) Inventor: Nezu, Akio Fujitsu Ltd Pat Dep Kosugi Fujitsu Bldg, Kawasaki-shi Kanagawa 211 (JP)
(74) Representative: Greenstreet, Cyril Henry

(56) References cited:
- EP-A- 0 004 238
- PATENT ABSTRACTS OF JAPAN, vol. 4, no. 189 (E-39)[671], 25th December 1980; & JP-A-55 130 170
- PATENT ABSTRACTS OF JAPAN, vol. 9, no. 240 (E-345)[1963], 26th September 1985; & JP-A-60 92 667

## Description

The present invention relates to a construction of a Metal Insulator Semiconductor Field Effect Transistor, referred to hereinafter as MIS FET. More particularly it relates to a construction designed to reduce leakage current caused by a parasitic transistor formed adjacent to an active region of the MIS FET.

Among FET semiconductor devices, the MIS FET (known as a MOS FET when an oxide film is used as the insulator) is most popularly used. To get a large output current from a MIS FET, it is necessary to design it with a long gate width. For this purpose many designs are used in practice.

When the MIS FET is incorporated in an IC (Integrated Circuit), interconnection wirings to source and drain electrodes are formed on a dielectric film formed over a substrate. In some cases a part of the wiring adjacent to the active region of the MIS FET induces an inversion layer beneath the surface of the substrate and forms a parasitic transistor collaborating with the drain and source regions of the MIS FET.

If a high voltage is applied to the drain wiring, it induces the inversion layer, and the parasitic transistor gives rise to a leakage current. The present invention provides a pattern of gate electrode which suppresses the above mentioned leakage current in such conditions.

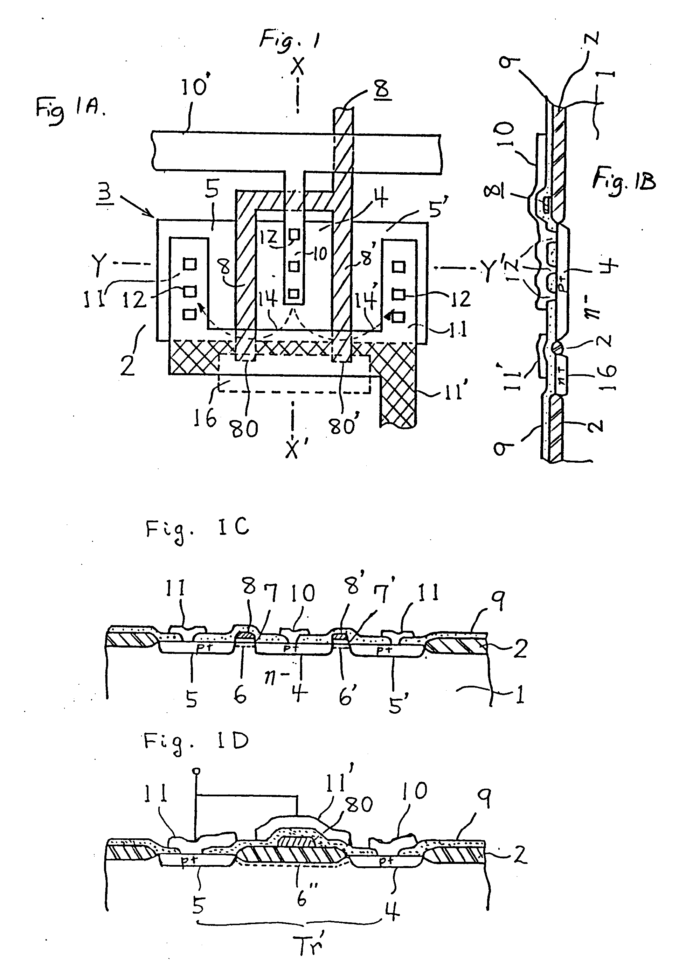

An example of a previously known MIS FET is shown in Fig. 1. Fig. 1A is a plan view of a twin MIS FET having a common source, and Fig. 1B and Fig. 1C show cross sectional views taken along chained lines X-X' and Y-Y' in Fig. 1A respectively.

The following disclosure refers to such twin MIS FET's, but it will be clear to the man skilled in the art that it is not limited to such a structure and is applicable to any type of FET.

In Fig. 1, an n⁻ type substrate 1 is used, and a field oxide film 2 is formed on a surface of the substrate 1. The field oxide film 2 has an opening for an active region 3 of the MIS FET, which comprises a source region 4, two drain regions 5 and 5', and two channel regions 6 and 6'.

The channel regions 6 and 6' are covered with gate insulating films 7 and 7' respectively (they are usually oxide films), and polycrystalline silicon gate electrodes 8 and 8' are formed thereon. The source and drain regions are formed by an ion implantation technique, for example, using the field oxide film 2 and the gate electrodes 8 and 8' as a mask. In this case, p⁺ type impurities are implanted into the MIS FET active region 3, and the p⁺ type regions of source and drain are formed.

After the formation of the source and drain regions, an insulating layer 9, a PSG (Phosphosilicate Glass) layer, for example, is formed by a CVD (Chemical Vapor Deposition) method. Contact windows 12 for the source and drain electrodes are formed in the insulating layer 9.

Subsequently an aluminum layer is deposited all over the surface of the substrate so that a source electrode 10, a source wiring 10', two drain electrodes 11 and a drain wiring 11' are formed by a selective etching process using photolithographic technique.

The above mentioned MIS FET structure shown in Fig.1 has two drain regions 5 and 5', one common source region 4 and two channel regions 6 and 6'. This design contributes to getting a large source-to-drain current I_{DS} and consequently a large transconductance gₘ suitable for a p channel open-drain output circuit.

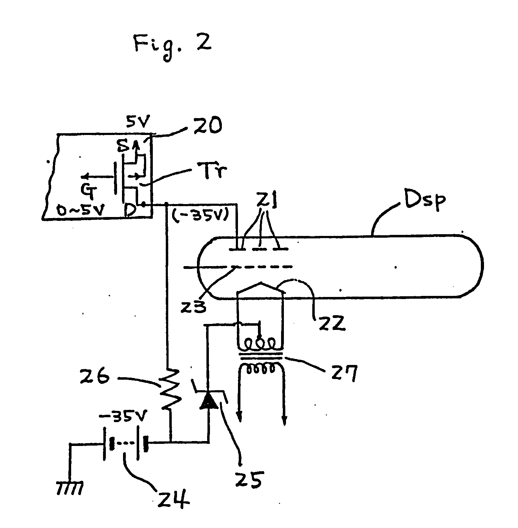

When the p channel MIS FET mentioned above is used in a driving circuit for a fluorescent display tube, for example, a negative voltage of about -35 volts is applied to the drain wiring 11'. Fig. 2 shows a circuit diagram of such an application.

In Fig. 2, reference character Tr designates a p channel MIS FET assembled in an IC 20; Dsp is a fluorescent display tube driven by IC 20, an anode electrode 21 of the display tube Dsp is connected to the output of the FET Tr, of which source, drain and gate electrodes are represented by S, D and G respectively. A negative terminal of a power supply 24 is connected to a center tap of a transformer 27, which is connected to a heater 22 of Dsp, via a Zener diode 25, and is also connected to the drain D of Tr via a register 26. A connection of a grid electrode 23 of Dsp is not shown because of simplicity.

When the MIS FET Tr is conductive, the voltage drop between the source S and drain D of the MIS FET Tr is about a few volts, and most voltage of the power supply 24 is applied to the fluorescent display tube Dsp.

When the gate voltage of Tr is driven to a cut off level, the voltage of the power supply is applied to the drain D of the MIS FET Tr. As shown in Fig. 2, when the negative voltage of the power supply 24 is -35 volts, for example, the drain voltage of the MIS FET becomes almost -35 volts.

In Fig. 1A, when the voltage of drain wiring 11' becomes -35 volts, an inversion layer is formed at the cross-shaded portion of the n⁻ substrate beneath the drain wiring 11'. A channel 6'' of the parasitic transistor Tr' is formed as shown in Fig. 1D. The p channel parasitic transistor Tr', shown in Fig. 1D, is composed of a source region 4, a drain region 5, a channel region 6'', and a gate electrode 80 (an elongated portion of the gate electrode 8 which is explained later) and drain wiring 11' as a second upper gate electrode. The current flowing in these parasitic transistors causes a leakage current of the main transistor Tr.

The leakage current due to the parasitic transistor Tr' mentioned above can be reduced by the following methods. The first method is to elongate the gate electrodes 8 and 8' straight across the area out of the MIS FET active region 3 and extend to the region of the cross shaded portion 11' as shown by dashed lines 80 and 80' of the gate electrodes 8 and 8'. The method suppresses the leakage current to some degree as a function of the positive voltage of the gate electrode 80 and 80'.

The second method is to form a channel stopper in the area where the parasitic transistor Tr' is formed. An n⁺ channel stopper 16 of the rectangular shape shown by the dashed line in Fig. 1A is formed by the ion implantation technology at an early stage of a wafer process. The n⁺ channel stopper 16 prevents the induction of the inversion layer in the substrate.

The above mentioned methods of reducing the leakage current are conventional in the art, but are still not enough to shut off the leakage current completely. With regard to the first method, if the voltage applied to the drain wiring 11' is high compared with that of the gate electrode 8o, the gate electrode cannot wholly prevent the formation of the inversion layer, and, as a result, the channel 6'' for the parasitic transistor Tr' is formed.

As for the second method of suppressing the leakage current forming the channel stopper 16, it is preferable to form the channel stopper 16 as close as possible to the active region 3 of the MIS FET. Usually the channel stopper is formed directly under the field oxide film 2 which is formed in contact with the active regions. Such method is well known as LOCOS method.

Moreover in a transistor required to operate at high voltage, the channel stopper cannot be provided close to the active region, because it decreases the break-down voltage at the pn junction of the drain or source regions 5, 5', 4 to the channel stopper 16.

As shown in Fig. 1A, the channel stopper 16 is formed in an opening window formed in the field oxide film 2, and a short distance apart from the MIS FET active region 3. As a result the formation of the inversion layer and the leakage current cannot be avoided.

The leakage current through the parasitic transistor will increase the wasted power consumption and cause a temperature rise of the MIS FET. On the other side, as a result of deterioration of the MIS FET characteristic, for example, the fluorescent display tube will glow partially in the display screen even when it should be cut off.

JP-A-60 92 667 by the present applicant discloses a MIS transistor structure having the features of the preamble of accompanying claim 1. The gate electrode has an extension formed on a field oxide region under a drain wiring thereby preventing the formation of an inverted layer under the extensions.

JP-A-55 130 170 by Hitachi discloses a MIS transistor structure in which the gate of the MIS transistor is extended to isolate the source or drain regions from a parasitic channel preventive region.

According to the present invention, there is provided a MIS FET semiconductor device comprising a semiconductor substrate of a first conductivity type, a field oxide film formed on said substrate and having an opening defining an active region in said substrate, said active region comprising a source region, a drain region and a channel region disposed between said source and drain regions, said source and drain regions having a second conductivity type opposite the first conductivity type, said MIS FET semiconductor device further comprising a gate insulating film formed on said channel region, a gate electrode formed on said gate insulating film, an insulation layer covering the entire surface of the substrate, a drain electrode formed on said insulating layer connected to said drain region through contact holes formed in said insulating layer, and a drain wiring formed on said insulating layer and connected to said drain electrode said drain wiring extending from the drain region to said source region along the boundary between said active region and said field oxide region; characterized in that said gate electrode has an extension formed at least partially on another portion of gate insulating film within said active region and along said boundary under said drain wiring.

Thus, in the present invention, a gate electrode of the FET is extended along the boundary region between the active region and the field oxide film of said MIS FET and under its drain wiring, to provide the FET with an additional gate electrode, hereinafter referred to as an extension of the gate electrode (extended gate electrode).

Embodiments of the present invention provide a gate electrode pattern to minimize the leakage current caused by the parasitic transistor and/or shut off effectively the flow of the leakage current through the parasitic transistor; and allow the gate electrode pattern to be formed with no additional wafer processes.

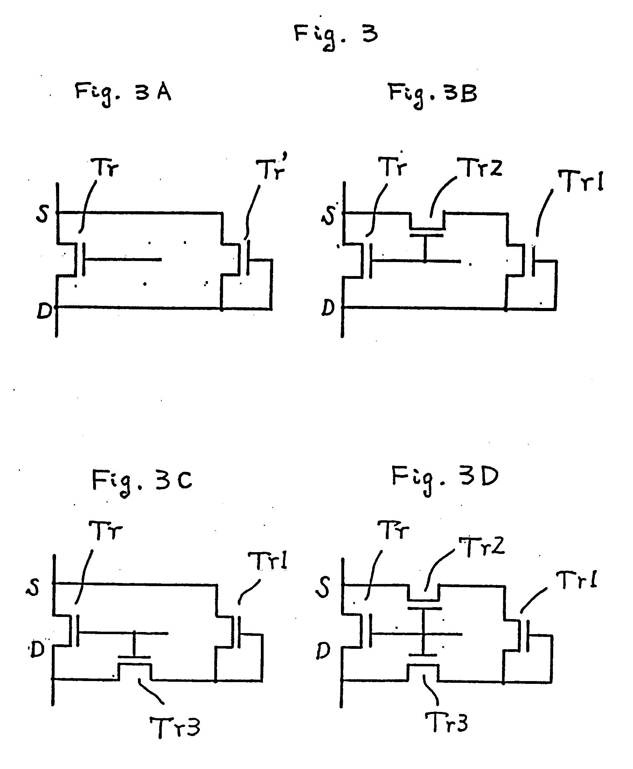

The parasitic transistor Tr' which gives rise to the leakage current is considered to be connected in parallel with the MIS FET Tr. This is schematically shown in the equivalent circuit of Fig. 3A. In the prior art circuit, parasitic transistor Tr' is not cut off perfectly, causing a leakage current.

The present invention provides an additional extended gate electrode which is connected to the gate electrode of Tr. If the additional extended gate is provided for the source region of Tr, the parasitic transistor Tr' becomes a FET with a dual-gate. The function of Tr' in this case is easily understood by separating Tr' into two serially connected FETs of Tr1 and Tr2 as shown in Fig. 3B.

In a first embodiment of the present invention, the gate of the first transistor Tr1 is composed of the drain wiring, and the gate of the second transistor Tr2 is composed of the extended gate of the main transistor Tr. Tr2 has a function of interrupting the leakage current.

In a second embodiment, the extended gate electrode is applied to the drain region and the parasitic transistor Tr' may be considered as divided into Tr1 and Tr3, which are connected in series as shown in Fig. 3C.

In a third embodiment, the extended gate electrode is applied to both of the source and the drain regions, and the parasitic transistor Tr' may be considered as three transistors Tr1, Tr2, and Tr3 connected in series, which is shown in Fig. 3D.

When the main MIS FET Tr is driven to a cut off level, and even if the Tr1 becomes conductive because of a negative high voltage of the drain wiring, Tr2 or Tr3 becomes non conductive and interrupts the leakage current of Tr1.

Embodiments of the invention will now be described in more detail, by way of example, with reference to the accompanying drawings forming a part hereof, wherein like numerals refer to like parts throughout, and in which:
Fig. 1A shows a plan view of a pattern of a previously proposed MIS FET.
Figs. 1B through 1D show a cross-sectional view of the MIS FET taken along chained lines X-X', Y-Y', and a dashed curve 14 respectively in Fig. 1A.
Fig. 2 is a circuit diagram showing an application of a MIS FET used as a driver of a fluorescent display tube.
Figs. 3A through 3D show equivalent circuit diagrams of the MIS FET illustrating a parasitic transistor and an additional transistor to prevent a leakage current: wherein
Fig. 3A shows an equivalent circuit diagram for the previously proposed MIS FET in which a parasitic transistor Tr' is formed in parallel with the main transistor Tr.
Fig. 3B shows an equivalent circuit diagram for a first embodiment of the invention in which the gate electrode of an additional transistor Tr2 is provided in the source region of the main transistor Tr;
Fig. 3B shows an equivalent circuit diagram for a second embodiment of the invention in which the gate electrode of an additional transistor Tr3 is provided in the drain region of the main transistor Tr;
Fig. 3D shows an equivalent circuit diagram for a third embodiment of the invention in which the gate electrodes of additional transistors are provided in both the source and drain regions of the main transistor Tr.

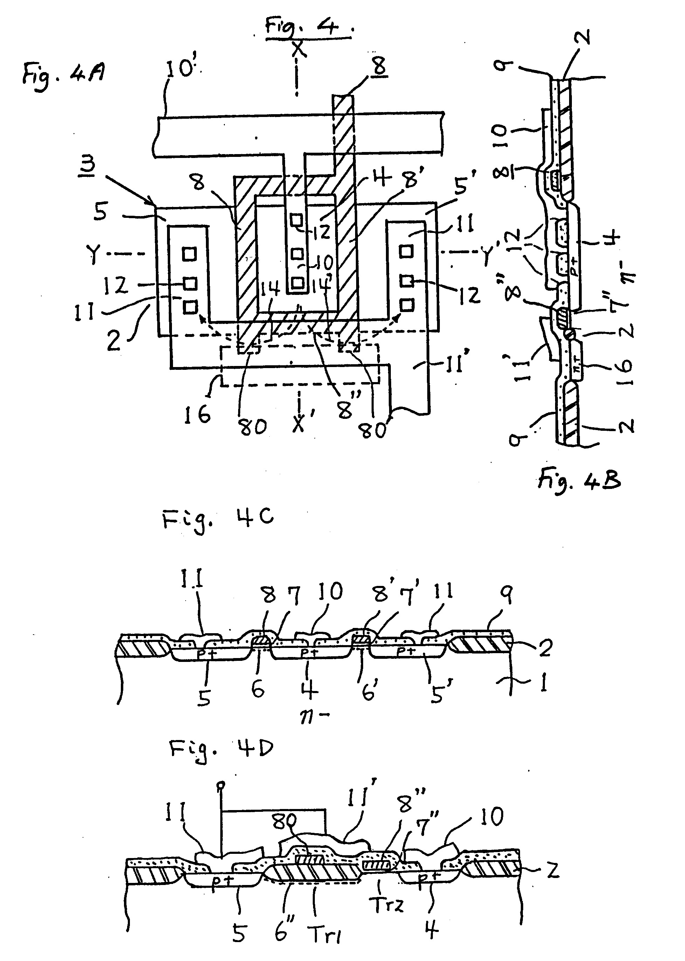

Fig. 4A shows a plan view of a pattern for a MIS FET of a first embodiment of the present invention, wherein the extended gate is applied for the source region of main FET.
Figs. 4B through 4D show a cross-sectional view taken along chained lines X-X', Y-Y', and a dashed curve 14 respectively in Fig. 4A.

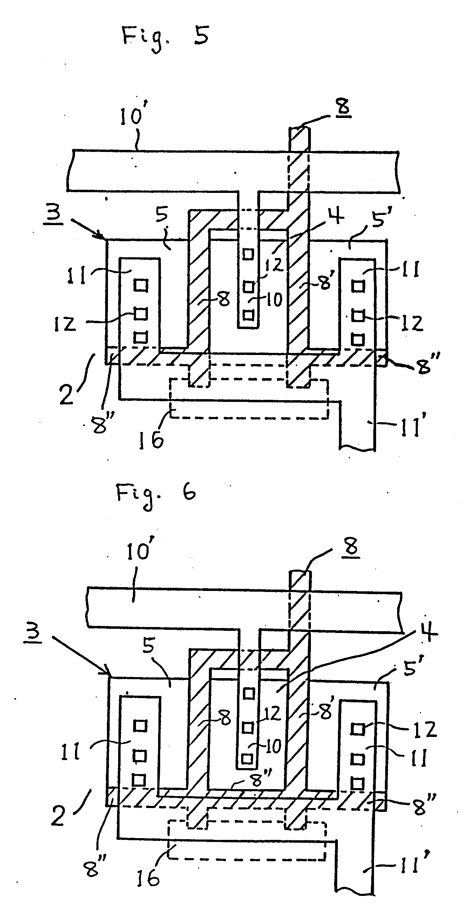

Fig. 5 shows a plan view of a pattern for a MIS FET of second embodiment of the present invention, wherein the extended gate is applied for the drain region of main FET.
Fig. 6 shows a plan view of a MIS FET of a third embodiment of the present invention, wherein the extended gate is applied for both source and drain regions of main FET.

In producing the embodiment shown in Figs. 4A through 4D, an n⁻ type silicon substrate is used. The substrate 1 is covered with a double layer of silicon dioxide and silicon nitride films (not shown), and then the layer is selectively etched off for a field oxide film region. Subsequently the substrate is subject to oxidation. The field oxide film 2 having a thickness of from 300 to 500 nm (3000 to 5000 Å) is grown all over the surface of the substrate 1, so that openings for a MIS FET active region 3 and a channel stopper region 16' (a channel stopper 16 is formed later) are automatically formed.

Unlike the usual case, the channel stopper region region 16' is not formed around the active region 3, but it is formed only at a portion parallel to one edge of the active region 3.

The size and position of the channel stopper region 16' is determined taking into consideration the break down voltage between the channel stopper 16 and the active region 3. It is desirable to design the channel stopper 16 as wide as possible beneath the drain wiring 11' to prevent the growth of the inversion layer caused by a voltage applied to the drain wiring 11'.

Thereafter the double layer of silicon dioxide and silicon nitride films is removed. The substrate is again subject to thermal oxidation. and then a silicon oxide film having a thickness of from 30 to 100 nm (300 to 1000 Å) is formed over the substrate. Then a polycrystalline silicon layer is deposited on the substrate by a chemical vapor deposition (CVD) to a thickness of from 400 to 500 nm (4000 to 5000 Å).

The silicon dioxide film and the polycrystalline silicon layer are selectively removed by a conventional photolithography technique. A plasma etching is used to selectively remove the polycrystalline silicon layer, and an etching solution comprising HF (hydrofluoric acid) is used to selectively remove the silicon dioxide film.

The silicon dioxide film thus formed on the channel region 6 and 6' constitutes a gate oxide film 7 and 7'. The polycrystalline silicon layer remaining on the gate oxide film constitutes respectively gate electrodes 8 and 8', and an additional extended gate electrode 8'' which extends along the boundary of the active region 3. They are connected by an interconnection wiring 8 to form IC.

These fabrication processes used for the gate electrodes 8, 8' and 8'', and wiring 8 are well known in the art of a MOS FET gate fabrication. Comparing the pattern of Fig. 4A with that of Fig. 1A, the pattern of Fig. 4A has an additional extended gate electrode 8'' (extension of the gate electrode 8, 8').

As can be seen,the extended gate electrode 8'' is connected at both its ends to the gate electrodes 8 and 8' and extends along the boundary region between the MIS FET active region 3 and the field oxide region 2. The pattern width of the extension 8'' is not critical, it may be the same as that of electrode 8 and 8'.

The extended gate electrode 8'' shown in Fig. 4 is formed on the gate oxide film 7'' in the active region 3 of the MIS FET, but this is not critical and it is permissible to form the extension 8'' partially on the field oxide film 2 along the boundary region.

Then n type impurity ions such as phosphorus or arsenic ions are selectively implanted for the channel stopper region 16. A dose of 3x10¹²/cm² and implantation energy of approximately 80 KeV are preferable.

Thereafter p type ions such as boron ions are implanted selectively for the source region 4 and the drain regions 5 and 5'. A dose of (5-10)x10¹⁴/cm² and implantation energy of approximately 60 KeV are preferable.

Subsequently a PSG layer 9 is deposited on the entire surface of the substrate by a CVD method to protect and insulate the surface of the device. The contact windows 12 for the source and drain regions 4, 5, 5' are formed by photolithography. Then an aluminum layer is deposited on the entire surface, and selectively etched forming the source electrode 10 and wiring 10', and the drain electrode 11 and wiring 11' by a well known photolithographic process.

Figs. 4B and 4C show a cross-sectional view taken along line X-X' and Y-Y' respectively. A dashed curve 14 with an arrow shows a direction of current flow in a parasitic transistor Tr' as explained in the prior art. Fig. 4D shows a cross-sectional view along the dashed curve 14.

Comparing Fig. 4D with Fig. 1D, the parasitic transistor Tr' has an extended gate electrode 8'' formed adjacent the source region 4. As has been described before, in the situation in which the main MIS FET Tr is non-conductive, the extension 8'' forms an interrupting transistor Tr2 and has a function of preventing a formation of an inversion layer, because the extension 8'' is formed in a position to shield a surface of the substrate from the drain wiring 11' as shown in Fig. 4D. Therefore even if the inversion layer is induced and a channel 6'' is formed beneath the gate electrode 80 and the drain wiring 11', the extended gate 8'' cuts off the channel 6'' and interrupts a leakage current from the source region 4 to the drain region 5. Fig. 3B is the equivalent circuit diagram for a structure shown in Fig. 4.

On the other hand, in the situation in which the main MIS FET Tr is conductive, the interruption transistor Tr2 is also conductive which means no problem.

Fig. 5 shows a second embodiment of the present invention having a different pattern of the suppression gate electrode. Referring to Fig. 5, the extensions 8'' of the gate electrode extend over the drain regions 5 and 5'.

Therefore the extensions 8'' have the form of outward extensions in opposite directions from the electrodes 8 and 8' respectively.

Except for the gate formation of the MIS FET, the structure of the Fig. 5 is almost the same as to that of Fig. 4. The extensions 8'' are formed on the opposite sides of the electrode (8, 8') to the case shown in Fig. 4D. Thus the interrupting transistor Tr3 is formed at the drain side of the main MIS FET. An equivalent circuit of Fig. 5 is shown as Fig. 3C.

Third preferred embodiment of the present invention is shown in Fig. 6. This type is a combination of the structures shown in Figs. 4 and 5. The extensions 8'' of the gate electrode are provided on both sides of the source 4 and drain regions 5 and 5'. Therefore the parasitic transistor Tr' has two extended gate electrodes 8''. An equivalent circuit diagram is shown as Fig. 3D. Two interrupting transistors Tr2 and Tr3 are formed in series, and more perfectly shut off the leakage current.

Among the three types of the present invention, the type as shown in Fig. 6 is more effective in suppressing the leakage current than the others.

It will be clear to the man skilled in the art that the embodiments as herein disclosed with respect to a p channel MIS FET can be easily modified for an n channel MIS FET by reversing the conductivity type and the polarity of the applied voltage.

The channel stopper described with respect to the embodiments is not limited to the form illustrated in the Figs.

It is possible to form a channel stopper surrounding the MIS FET active region 3, or to form the channel stopper directly under the field oxide film.

The form of source and drain region and the pattern of each electrode and wiring may be also modified.

It will be seen that the invention provides a MIS FET having an additional gate electrode (referred to as an extended gate electrode) which extends along a boundary region between a MIS FET active region and a field oxide film under a drain wiring. When the drain wiring is impressed to a voltage high enough to induce in the substrate an inversion layer of the same polarity as the MIS FET channel, a parasitic transistor Tr₁ is formed in parallel with the MIS FET and increases the leakage current. The extended gate electrode of the present invention forms an interrupting transistor Tr₂ connected in series with the parasitic transistor and cuts off the leakage current.

## Claims

1. A MIS FET semiconductor device comprising a semiconductor substrate of a first conductivity type, a field oxide film (2) formed on said substrate and having an opening defining an active region (3) in said substrate, said active region (3) comprising a source region (4), a drain region (5, 5') and a channel region (6, 6') disposed between said source and drain regions, said source and drain regions having a second conductivity type opposite the first conductivity type, said MIS FET semiconductor device further comprising a gate insulating film (7, 7') formed on said channel region (6, 6'), a gate electrode (8, 8') formed on said gate insulating film (7, 7'), an insulation layer (9) covering the entire surface of the substrate, a drain electrode (11) formed on said insulating layer (9) connected to said drain region through contact holes (12) formed in said insulating layer (9), and a drain wiring (11') formed on said insulating layer (9) and connected to said drain electrode (11), said drain wiring (11') extending from the drain region (5, 5') to said source region (4) along the boundary between said active region (3) and said field oxide region (2); characterized in that:-said gate electrode (8, 8') has an extension (8'') formed at least partially on another portion (7'') of gate insulating film within said active region (3) and along said boundary under said drain wiring (11').

2. A MIS FET semiconductor device according to claim 1, wherein said extension (8'') of the gate electrode (8, 8') extends across said source region (4).

3. A MIS FET semiconductor device according to claim 1, wherein said extension (8'') of the gate electrode (8, 8') extends across said drain region (5,5').

4. A MIS FET semiconductor device according to claim 1, wherein said extension (8'') of the gate electrode (8, 8') extends across said drain region (5,5') and across said source region (4).

5. A MIS FET semiconductor device according to any preceding claim, wherein said extension (8'') of the gate electrode (8, 8') is formed entirely within said active region (3).

6. A MIS FET semiconductor device according to any preceding claim, further comprising a channel stopper (16) formed under said field oxide film (2) and along said boundary under said drain wiring (11').

7. A MIS FET semiconductor device according to any of claims 1 to 5, further comprising a channel stopper (16) formed in an opening of said field oxide film (2), the opening being formed along said boundary under said drain wiring (11').

8. A MIS FET semiconductor device according to any preceding claim, where said gate insulating film is a silicon dioxide film.

## Patentansprüche

1. Eine MISFET-Halbleiteranordnung mit einem Halbleitersubstrat eines ersten Leitfähigkeitstyps, einem Feldoxidfilm (2), der auf dem genannten Substrat gebildet ist und eine Öffnung hat, die eine aktive Zone (3) in dem genannten Substrat definiert, welche aktive Zone (3) eine Sourcezone (4), eine Drainzone (5, 5') und eine Kanalzone (6, 6') umfaßt, die zwischen den genannten Source- und Drainzonen angeordnet ist, welche Source- und Drainzonen einen zweiten Leitfähigkeitstyp entgegengesetzt zu dem ersten Leitfähigkeitstyp haben, welche MISFET-Halbleiteranordnung ferner einen Gateisolierfilm (7, 7') umfaßt, der auf der genannten Kanalzone (6, 6') gebildet ist, eine Gateelektrode (8, 8'), die auf dem genannten Gateisolierfilm (7, 7') gebildet ist, eine Isolierschicht (9), die die gesamte Oberfläche des Substrats bedeckt, eine Drainelektrode (11), die auf der genannten Isolierschicht (9) gebildet und mit der genannten Drainzone durch Kontaktlöcher (12) verbunden ist, die in der genannten Isolierschicht (9) gebildet sind, und eine Drainverdrahtung (11'), die auf der genannten Isolierschicht (9) gebildet und mit der genannten Drainelektrode (11) verbunden ist, welche Drainverdrahtung (11') sich von der Drainzone (5, 5') zu der genannten Sourcezone (4) längs der Grenze zwischen der genannten aktiven Zone (3) und der genannten Feldoxidzone (2) erstreckt;
dadurch gekennzeichnet, daß:-
die genannte Gateelektrode (8, 8') eine Erweiterung (8'') hat, die wenigstens teilweise auf einem anderen Teil (7'') des Gateisolierfilms innerhalb der genannten aktiven Zone (3) und längs der genannten Grenze unter der genannten Drainverdrahtung (11') gebildet ist.

2. Eine MISFET-Halbleiteranordnung nach Anspruch 1, bei der sich die genannte Erweiterung (8'') der Gateelektrode (8, 8') über die genannte Sourcezone (4) erstreckt.

3. Eine MISFET-Halbleiteranordnung nach Anspruch 1, bei der sich die genannte Erweiterung (8'') der Gateelektrode (8, 8') über die genannte Drainzone (5, 5') erstreckt.

4. Eine MISFET-Halbleiteranordnung nach Anspruch 1, bei der sich die genannte Erweiterung (8'') der Gateelektrode (8, 8') über die genannte Drainzone (5, 5') und über die genannte Sourcezone (4) erstreckt.

5. Eine MISFET-Halbleiteranordnung nach irgendeinem vorhergehenden Anspruch, bei der die genannte Erweiterung (8'') der Gateelektrode (8, 8') vollständig innerhalb der genannten aktiven Zone (3) gebildet ist.

6. Eine MISFET-Halbleiteranordnung nach irgendeinem vorhergehenden Anspruch, die ferner einen Kanalstopper (16) umfaßt, der unter dem genannten Feldoxidfilm (2) und längs der genannten Grenze unter der genannten Drainverdrahtung (11') gebildet ist.

7. Eine MISFET-Halbleiteranordnung nach irgendeinem der Ansprüche 1 bis 5, die ferner einen Kanalstopper (16) umfaßt, der in einer Öffnung des genannten Feldoxidfilms (2) gebildet ist, welche Öffnung längs der genannten Grenze unter der genannten Drainverdrahtung (11') gebildet ist.

8. Eine MISFET-Halbleiteranordnung nach irgendeinem vorhergehenden Anspruch, bei der der genannte Gateisolierfilm ein Siliziumdioxidfilm ist.

## Revendications

1. Dispositif semiconducteur à transistor à effet de champ métalisolant-semiconducteur, ou MIS FET, comprenant un substrat semiconducteur d'un premier type de conductivité, une pellicule d'oxyde de champ (2) formée sur ledit substrat et possédant une ouverture qui définit une région active (3) dans ledit substrat, ladite région active (3) comprenant une région de source (4), une région de drain (5, 5') et une région de canal (6, 6') disposée entre lesdites régions de source et de drain, lesdites régions de source et de drain ayant un deuxième type de conductivité, opposé au premier type de conductivité, ledit dispositif semiconducteur MIS FET comprenant en outre une pellicule d'isolation de grille (7, 7') formée sur ladite région de canal (6, 6'), une électrode de grille (8, 8') formée sur ladite pellicule d'isolation de grille (7, 7'), une couche d'isolation (9) couvrant toute la surface du substrat, une électrode de drain (11) formée sur ladite couche d'isolation (9) et connectée à ladite région de drain par l'intermédiaire de trous de contact (12) formés dans ladite couche d'isolation (9), et un câblage de drain (11') formé sur ladite couche d'isolation (9) et connecté à ladite électrode de drain (11), ledit câblage de drain (11') s'étendant de la région de drain (5, 5') à ladite région de source (4) le long de la frontière entre ladite couche active (3) et ladite région d'oxyde de champ (2);
caractérisé en ce que ladite électrode de grille (8, 8') possède un prolongement (8'') formé au moins partiellement sur une autre partie (7'') de la pellicule d'isolation de grille à l'intérieur de ladite région active (3) et le long de ladite frontière sous ledit câblage de drain (11').

2. Dispositif semiconducteur MIS FET selon la revendication 1, où ledit prolongement (8'') de l'électrode de grille (8, 8') s'étend sur ladite région de source (4).

3. Dispositif semiconducteur MIS FET selon la revendication 1, où ledit prolongement (8'') de l'électrode de grille (8, 8') s'étend sur ladite région de drain (5, 5').

4. Dispositif semiconducteur MIS FET selon la revendication 1, où ledit prolongement (8'') de l'électrode de grille (8, 8') s'étend sur ladite région de drain (5, 5') et sur ladite région de source (4).

5. Dispositif semiconducteur MIS FET selon l'une quelconque des revendications précédentes, où ledit prolongement (8'') de l'électrode de grille (8, 8') est formé entièrement à l'intérieur de ladite région active (3).

6. Dispositif semiconducteur MIS FET selon l'une quelconque des revendications précédentes, comprenant en outre un élément d'arrêt de canal (16) formé sous ladite pellicule d'oxyde de champ (2) et le long de ladite frontière sous ledit câblage de drain (11').

7. Dispositif semiconducteur MIS FET selon l'une quelconque des revendications 1 à 5, comprenant en outre un élément d'arrêt de canal (16) formé dans une ouverture de ladite pellicule d'oxyde de champ (2), l'ouverture étant formée le long de ladite frontière sous ledit câblage de drain (11').

8. Dispositif semiconducteur MIS FET selon l'une quelconque des revendications précédentes, où ladite pellicule d'isolation de grille est une pellicule de dioxyde de silicium.
